# EUROPEAN PATENT APPLICATION

(11) **EP 4 780 156 A1**
(43) Date of publication of application: **22.07.2026**
(21) Application number: 26152539.8
(22) Date of filing: 19.01.2026
(51) Int. Cl.: H05K 7/20

(54) **SMOOTH LIQUID COOLING CONTROL**

(30) Priority: 21.01.2025 US 202563747884 P; 02.01.2026 US 202619439264
(71) Applicant: Vertiv Corporation, Westerville, OH 43082 (US)
(72) Inventor: TAKACS, BALINT, Westerville, 43082 (US); VOIGT, TYLER WILLIAM, Westerville, 43082 (US); SALEH, ADAM MUSTAFA, Westerville, 43082 (US); ULRICH, PHILIP ROBERT, Westerville, 43082 (US); KING, JEREMY RYAN, Westerville, 43082 (US)
(74) Representative: Cousens, Nico

(57) **Abstract**

A cooling system can include a first cooling loop for extracting heat from a load, a second cooling loop for rejecting the heat, and a controller for controlling one or more aspects of the first cooling loop and/or the second cooling loop. The first cooling loop can include a first heat exchanger for transferring heat from the load to a first cooling fluid, a second heat exchanger for transferring heat from the first cooling fluid to a second cooling fluid, and a flow control valve for controlling flow of the first cooling fluid through the first cooling loop. The controller can monitor a parameter and/or operate the flow control valve to maintain a temperature associated with the load. The controller can selectively boost a cooling capacity of the first cooling loop when a change in the parameter exceeds a threshold.

## Description

This application claims the benefit of U.S. Provisional Patent Application No. 63/747,884 filed January 21, 2025.

### TECHNICAL FIELD

The present disclosure relates generally to cooling systems, such as for use in data centers, and more specifically relates to managing load fluctuations in such cooling systems.

### BACKGROUND

Data center density and heat loads are increasing every year. Heat loads can fluctuate as computing and other demands fluctuate. In some cases, heat loads can go from about 0% to about 100% in a matter of seconds. Where the absolute size of the heat load change is relatively small, such a change may not be an issue. But, in some cases, heat load increases can be in the megawatt range, or even higher. Such a heat load increase is challenging to manage while minimizing overshooting, i.e., undercooling.

More specifically, a large increase in a heat load can cause a very high temperature of the cooling fluid leaving the load and/or a rapid change in the temperature of the fluid. A typical cooling system cannot react fast enough to adequately cool that fluid before it returns to the load. Even where a cooling system may be able to adequately cool that fluid before it returns to the load, such a cooling system typically cannot avoid over-cooling the fluid, such as when the heat load settles, inefficiently delivering fluid that is colder than desired.

### SUMMARY

Applicant has created new and useful devices, systems and methods for managing load fluctuations in cooling systems, such as those used in data centers. When there is a large increase in heat load, the temperature of the cooling fluid leaving the load can increase substantially. In at least one embodiment, a cooling system according to the disclosure can boost cooling capacity in response to a substantial increase in temperature and provide time for the cooling system to ramp up cooling capacity and accommodate the increase in temperature. In at least one embodiment, the boost can be temporary, such as by adding colder cooling fluid to excessively hot cooling fluid (which can be done before or after the cooling fluid enters the load) and/or replacing excessively hot cooling fluid with colder cooling fluid. In at least one embodiment, the boost can include adding additional cooling capacity, such as by activating another heat exchanger, which can include increasing a flow rate through the load and/or decreasing a flow rate (such as for more efficient heat transfer) through the heat exchangers.

In at least one embodiment, a cooling system according to the disclosure can include a first cooling loop for extracting heat from a load, a second cooling loop for rejecting the heat, a controller for controlling one or more aspects of the first cooling loop and/or the second cooling loop, or any combination thereof. In at least one embodiment, the first cooling loop can include a first heat exchanger for transferring heat from the load to a first cooling fluid (such as that circulating in the first cooling loop), a second heat exchanger for transferring heat from the first cooling fluid to a second cooling fluid (such as that circulating in the second cooling loop), a prime mover for circulating the first cooling fluid through at least a portion of the first cooling loop (such as the first heat exchanger and the second heat exchanger), a flow control valve for controlling flow of the first cooling fluid through the first cooling loop, or any combination thereof. In at least one embodiment, the controller can monitor a parameter and/or operate the flow control valve to maintain a load temperature associated with the load. In at least one embodiment, the controller can selectively boost a cooling capacity of the first cooling loop when a change in the parameter exceeds a threshold.

In at least one embodiment, the first heat exchanger can be a direct-to-chip heat exchanger. In at least one embodiment, the second heat exchanger can be a brazed plate heat exchanger. In at least one embodiment, the first cooling fluid can be a single-phase cooling fluid, such as water or a water/glycol mixture, and/or the prime mover can be a pump. In at least one embodiment, the first cooling fluid can be a two-phase refrigerant and/or the prime mover can be a compressor. In at least one embodiment, the first cooling fluid can be the same as the second cooling fluid.

In at least one embodiment, the parameter can be the load temperature. In at least one embodiment, the parameter and/or the load temperature can be a return temperature of the first cooling fluid exiting the first heat exchanger. In at least one embodiment, the parameter and/or the load temperature can be a supply temperature of the first cooling fluid entering the first heat exchanger. In at least one embodiment, the parameter can be an electrical power consumption of the load.

In at least one embodiment, boosting the cooling capacity of the first cooling loop can include reducing the temperature of the cooling fluid entering the first heat exchanger and/or the second heat exchanger, such as by replacing some or all of the hot cooling fluid circulating in the first cooling loop with colder cooling fluid. In at least one embodiment, boosting the cooling capacity of the first cooling loop can include replacing some or all of the first cooling fluid exiting or entering the first heat exchanger with colder cooling fluid, such as by drawing the colder cooling fluid into the first cooling loop between the first heat exchanger and the second heat exchanger. In at least one embodiment, boosting the cooling capacity of the first cooling loop can include replacing some or all of the first cooling fluid exiting the first heat exchanger with colder cooling fluid upstream of the second heat exchanger.

In at least one embodiment, boosting the cooling capacity of the first cooling loop can include diverting a first portion of the first cooling fluid exiting the first heat exchanger to a buffer tank, which can be plumbed in parallel with the flow control valve. In at least one embodiment, boosting the cooling capacity of the first cooling loop can include drawing a second portion of the first cooling fluid from the buffer tank. In at least one embodiment, the first portion can be hotter than the second portion. In at least one embodiment, the first portion can be volumetrically identical to the second portion.

In at least one embodiment, the controller can monitor a buffer temperature of the first cooling fluid in the buffer tank and replace, such as when the buffer temperature exceeds a second threshold, a third portion of the first cooling fluid in the buffer tank with a fourth portion of the second cooling fluid, such as from the second cooling loop. In at least one embodiment, the third portion can be volumetrically identical to the fourth portion.

In at least one embodiment, during normal operations, such as when the return temperature is not changing rapidly and/or when the change in the return temperature is below a first (or other) threshold, the controller can operate the flow control valve normally, such as proportionally to the return temperature. In at least one embodiment, when the change in the return temperature exceeds the first threshold and is below a second (or other) threshold, the controller can reduce flow through the flow control valve and replace some of the first cooling fluid exiting the first heat exchanger, such as at a higher temperature, with colder cooling fluid stored in a buffer tank, which can be plumbed in parallel with the flow control valve. In at least one embodiment, when the change in the return temperature exceeds the second threshold, the controller can operate the flow control valve normally, such as proportionally to the return temperature, and replace some of the first cooling fluid exiting the first heat exchanger with the colder cooling fluid stored in the buffer tank. In at least one embodiment, the second threshold can be greater than the first threshold.

In at least one embodiment, when the change in the parameter is below the first threshold (i.e., during normal operations), the controller can maintain the temperature associated with the load by controlling a flow rate of the first cooling fluid through the first cooling loop, such as through control of the flow control valve and/or the prime mover. In at least one embodiment, when the change in the parameter exceeds the first threshold (i.e., during abnormal operations), the controller can boost the cooling capacity of the first cooling loop by increasing the flow rate and/or a volume of the first cooling fluid flowing through the first cooling loop, such as through control of the flow control valve, the prime mover, one or more other valves, or any combination thereof.

In normal operations, the return temperature is expected to fluctuate to some extent. In at least one embodiment, when there are minimal and/or normal fluctuations (such as when the change in the return temperature is below the first threshold), the controller can operate the flow control valve normally, such as proportionally to the return temperature and/or according to a normal operations control scheme, which can be based at least in part on the temperature associated with the load.

In at least one embodiment, when there is a minor fluctuation (such as when the change in the return temperature exceeds the first threshold and is below a second threshold), the controller can operate the flow control valve more dramatically than otherwise called for by the return temperature itself, such as opening the flow control valve disproportionally greater and/or more than that called for by the scheme. In at least one embodiment, by opening the flow control valve disproportionally greater and/or more dramatically, the controller can react faster to the change in the return temperature and/or accommodate minor fluctuations beyond normal operations.

In at least one embodiment, when there is a moderate fluctuation (such as when the change in the return temperature exceeds the second threshold and is below a third threshold), the controller can replace some of the hotter cooling fluid exiting the first heat exchanger with colder cooling fluid, with or without increasing a flow rate of the cooling fluid through the first cooling loop. In at least one embodiment, when there is a moderate fluctuation (such as when the change in the return temperature exceeds the second threshold and is below a third threshold), the controller can reduce flow through the flow control valve and replace some or all of the first cooling fluid exiting the first heat exchanger with colder cooling fluid stored in a buffer tank, which can be plumbed in parallel with the flow control valve.

In at least one embodiment, when there is a more dramatic fluctuation (such as when the change in the return temperature exceeds the third threshold), the controller can operate the flow control valve normally, such as proportionally to the return temperature and/or according to the scheme, and replace some of the first cooling fluid exiting the first heat exchanger with the colder cooling fluid stored in the buffer tank. In at least one embodiment, when there is a more dramatic fluctuation (such as when the change in the return temperature exceeds the third threshold), the controller can maintain flow through the flow control valve and replace some of the first cooling fluid exiting the first heat exchanger with colder cooling fluid stored in the buffer tank. In at least one embodiment, when there is a more dramatic fluctuation (such as when the change in the return temperature exceeds the third threshold), the controller can maintain flow through the flow control valve and draw some or all of the colder cooling fluid stored in the buffer tank into the first cooling loop. In at least one embodiment, the second threshold can be greater than the first threshold. In at least one embodiment, the third threshold can be greater than the first threshold and/or the second threshold.

In at least one embodiment, boosting the cooling capacity of the first cooling loop can include inducing the first cooling fluid to flow through a third heat exchanger. In at least one embodiment, the third heat exchanger can be plumbed in parallel with the second heat exchanger and/or transfer heat from the first cooling fluid to another cooling fluid (such as the second cooling fluid). In at least one embodiment, inducing the first cooling fluid to flow through the third heat exchanger can increase a flow rate through the first heat exchanger and/or reduce a flow rate through the second heat exchanger. In at least one embodiment, the controller can induce the first cooling fluid to flow through the first heat exchanger at a first flow rate, induce the first cooling fluid to flow through the second heat exchanger at a second flow rate, induce the first cooling fluid to flow through the third heat exchanger at a third flow rate, or any combination thereof. In at least one embodiment, the first flow rate can be higher than the second flow rate and/or the third flow rate. In at least one embodiment, the first flow rate can be equal to the sum of the second flow rate and the third flow rate.

In at least one embodiment, boosting the cooling capacity of the first cooling loop can include increasing a flow rate and/or a volume of the first cooling fluid through the first cooling loop. In at least one embodiment, boosting the cooling capacity of the first cooling loop can include drawing additional cooling fluid from a buffer tank, which can be plumbed in parallel with a portion of the first cooling loop, such as the flow control valve. In at least one embodiment, boosting the cooling capacity of the first cooling loop can include diverting at least a portion of the first cooling fluid exiting the first heat exchanger and/or the second heat exchanger to a buffer tank.

### BRIEF DESCRIPTION OF THE DRAWINGS

FIG. 1 is a simplified flow diagram of one of many embodiments of a cooling system according to the disclosure.
FIG. 2 is a simplified flow diagram of another one of many embodiments of a cooling system according to the disclosure.
FIG. 3 is a flow chart of one of many embodiments of a control scheme for a cooling system according to the disclosure.
FIG. 4 is a flow chart of another one of many embodiments of a control scheme for a cooling system according to the disclosure.
FIG. 5 is a partial schematic diagram of one of many embodiments of a cooling system according to the disclosure.
FIG. 6 is a simplified diagram of one of many embodiments of a closed buffer tank for use with a cooling system according to the disclosure.
FIG. 7 is a simplified diagram of one of many embodiments of an open buffer tank for use with a cooling system according to the disclosure.
FIG. 8 is a simplified flow diagram of one of many embodiments of a cooling system having a buffer tank that is closed from the cold and hot liquid sides according to the disclosure.
FIG. 9 is a simplified flow diagram of one of many embodiments of a cooling system having a buffer tank that is open from the cold liquid side and closed from the hot liquid side according to the disclosure.
FIG. 10 is a simplified flow diagram of one of many embodiments of a cooling system having a buffer tank that is closed from the cold liquid side and open from the hot liquid side according to the disclosure.

### DETAILED DESCRIPTION

The figures described above and the written description of specific structures and functions below are not presented to limit the scope of what Applicant has invented or the scope of the appended claims. Rather, the figures and written description are provided to teach any person skilled in the art to make and use the inventions for which patent protection is sought. Those skilled in the art will appreciate that not all features of a commercial embodiment of the inventions are described or shown for the sake of clarity and understanding. Persons of skill in this art will also appreciate that the development of an actual commercial embodiment incorporating aspects of the present inventions will require numerous implementation-specific decisions to achieve the developer's ultimate goal for the commercial embodiment. Such implementation-specific decisions may include, and likely are not limited to, compliance with system-related, business-related, government-related and other constraints, which may vary by specific implementation, location and from time to time. While a developer's efforts might be complex and time-consuming in an absolute sense, such efforts would be, nevertheless, a routine undertaking for those of skill in this art having benefit of this disclosure. It must be understood that the inventions disclosed and taught herein are susceptible to numerous and various modifications and alternative forms.

The use of a singular term, such as, but not limited to, "a," is not intended as limiting of the number of items. Also, the use of relational terms, such as, but not limited to, "top," "bottom," "left," "right," "upper," "lower," "down," "up," "side," and the like are used in the written description for clarity in specific reference to the figures and are not intended to limit the scope of the disclosures or the appended claims. The terms "including" and "such as" are illustrative and not limitative. The terms "couple," "coupled," "coupling," "coupler," and like terms are used broadly herein and can include any method or device for securing, binding, bonding, fastening, attaching, joining, inserting therein, forming thereon or therein, communicating, or otherwise associating, for example, mechanically, magnetically, electrically, chemically, operably, directly or indirectly with intermediate elements, one or more pieces of members together and can further include without limitation integrally forming one functional member with another in a unity fashion. The coupling can occur in any direction, including rotationally. Further, all parts and components of the disclosure that are capable of being physically embodied inherently include imaginary and real characteristics regardless of whether such characteristics are expressly described herein, including but not limited to characteristics such as axes, ends, inner and outer surfaces, interior spaces, tops, bottoms, sides, boundaries, dimensions (e.g., height, length, width, thickness), mass, weight, volume and density, among others.

Any process flowcharts discussed herein illustrate the operation of possible implementations of systems, methods, and computer program products according to various embodiments of the present disclosure. In this regard, each block in a flowchart may represent a module, segment, or portion of code, which can comprise one or more executable instructions for implementing the specified logical function(s). It should also be noted that, in some implementations, the function(s) noted in the block(s) might occur out of the order depicted in the figures. For example, blocks shown in succession may, in fact, be executed substantially concurrently. It will also be noted that each block of a flowchart illustration can be implemented by special purpose hardware-based systems that perform the specified functions or acts, or combinations of special purpose hardware and computer instructions.

Applicant has created new and useful devices, systems and methods for managing load fluctuations in cooling systems, such as those used in data centers. When there is a large increase in heat load, the temperature of the cooling fluid leaving the load can increase substantially. In at least one embodiment, a cooling system according to the disclosure can boost cooling capacity in response to a substantial increase in temperature and provide time for the cooling system to ramp up cooling capacity and accommodate the increase in temperature. In at least one embodiment, the boost can be temporary, such as by adding colder cooling fluid to excessively hot cooling fluid (which can be done before or after the cooling fluid enters the load) and/or replacing excessively hot cooling fluid with colder cooling fluid. In at least one embodiment, the boost can include adding additional cooling capacity, such as by activating another heat exchanger, which can include increasing a flow rate through the load and/or decreasing a flow rate (such as for more efficient heat transfer) through the heat exchangers.

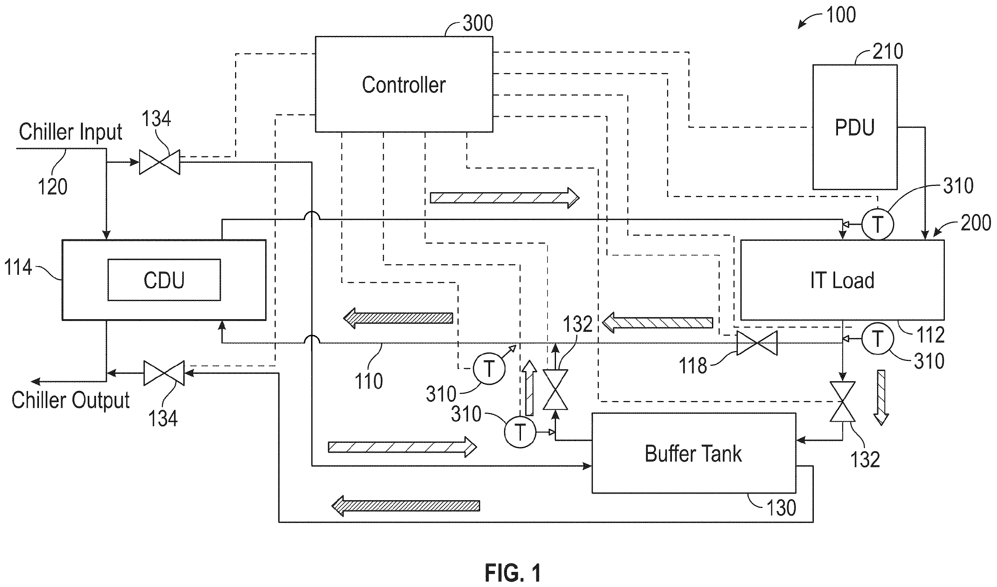

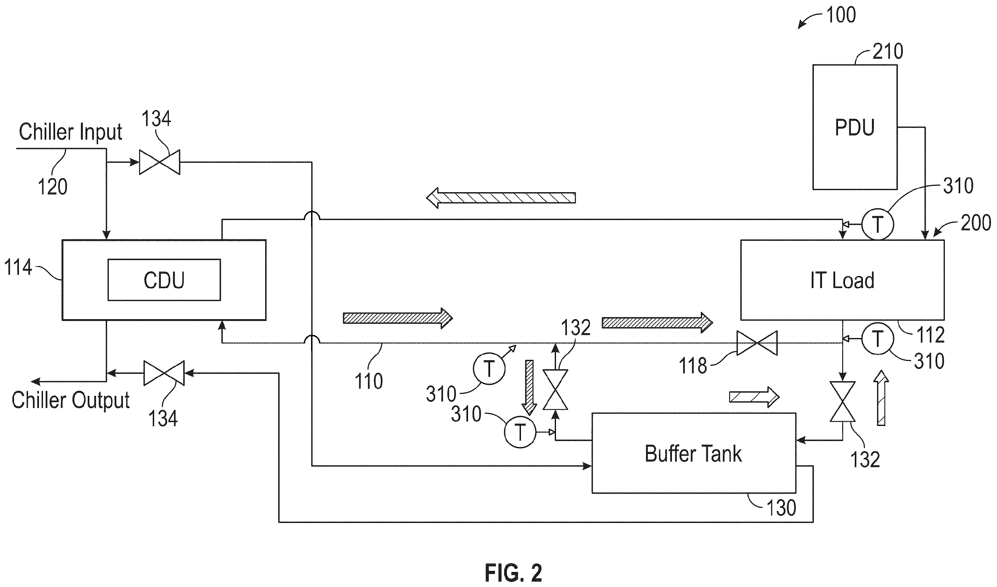

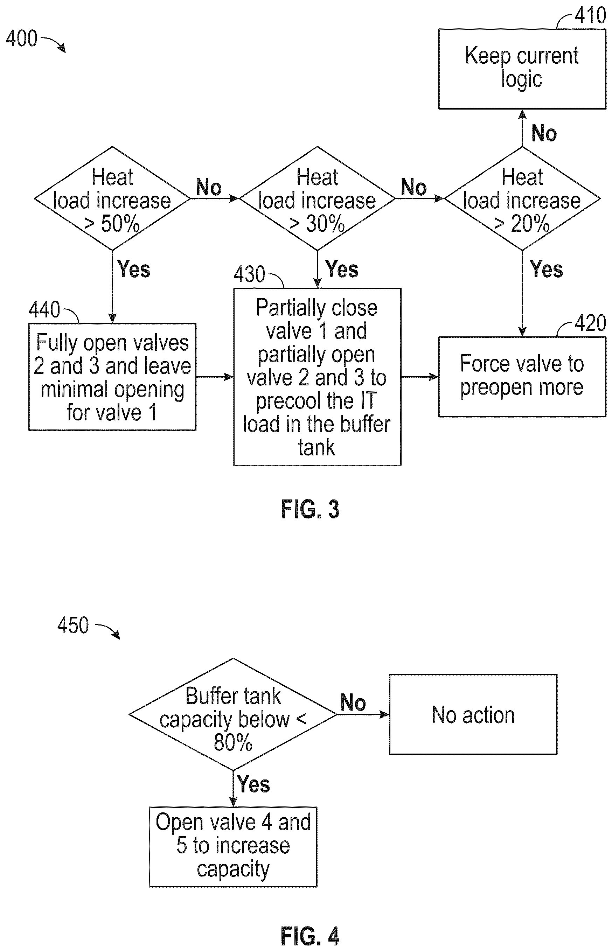

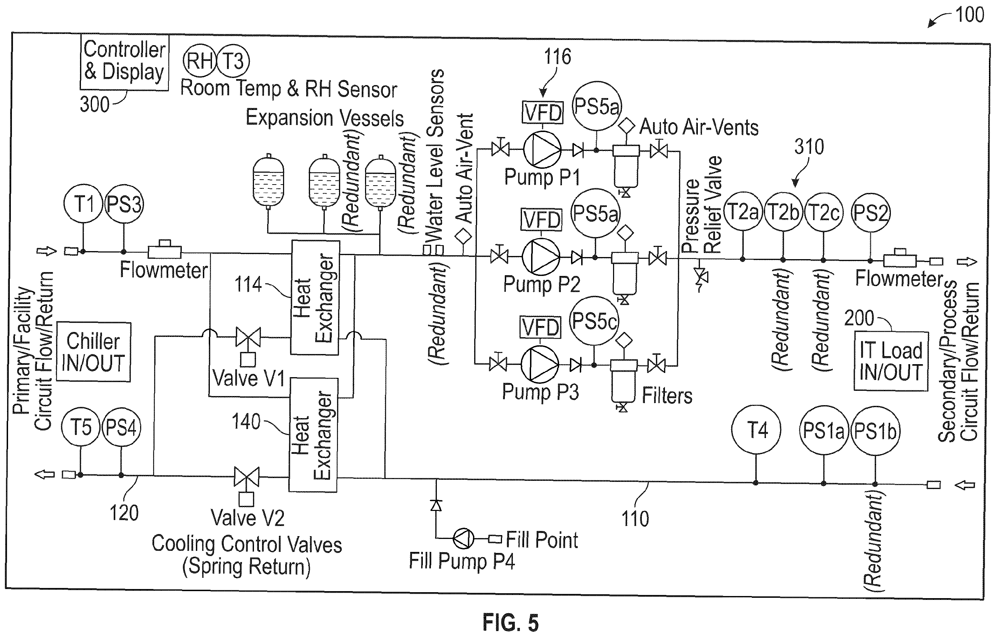

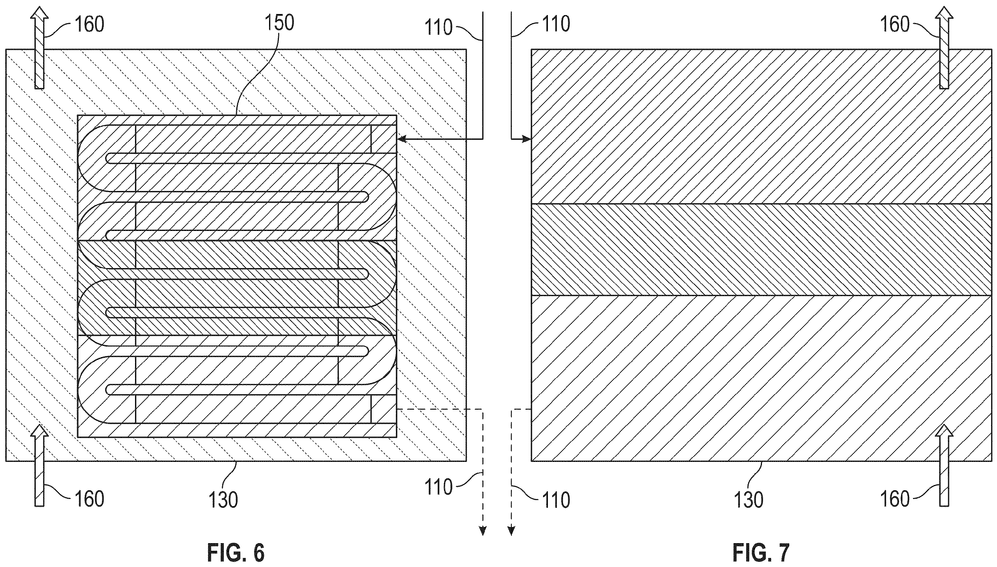

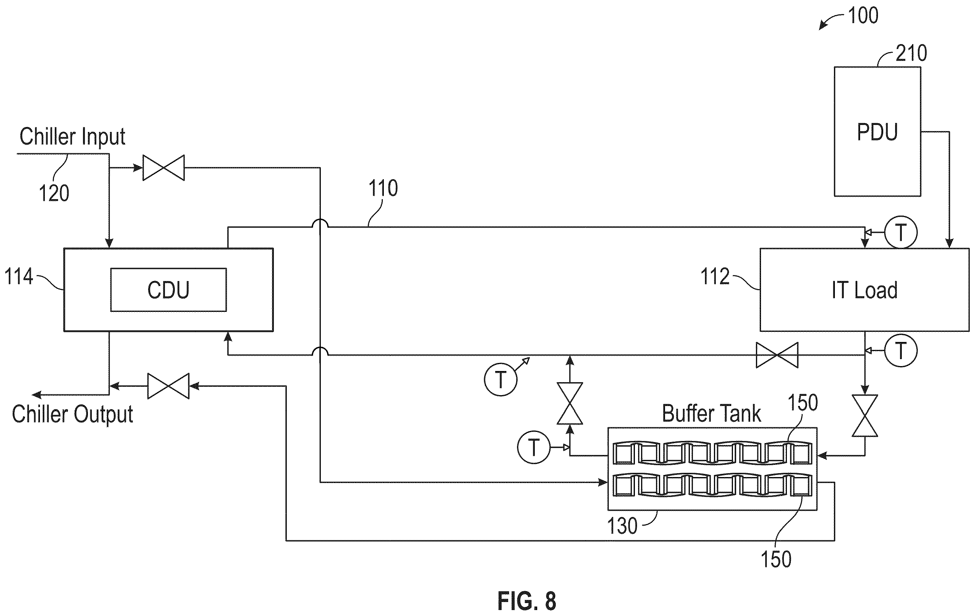

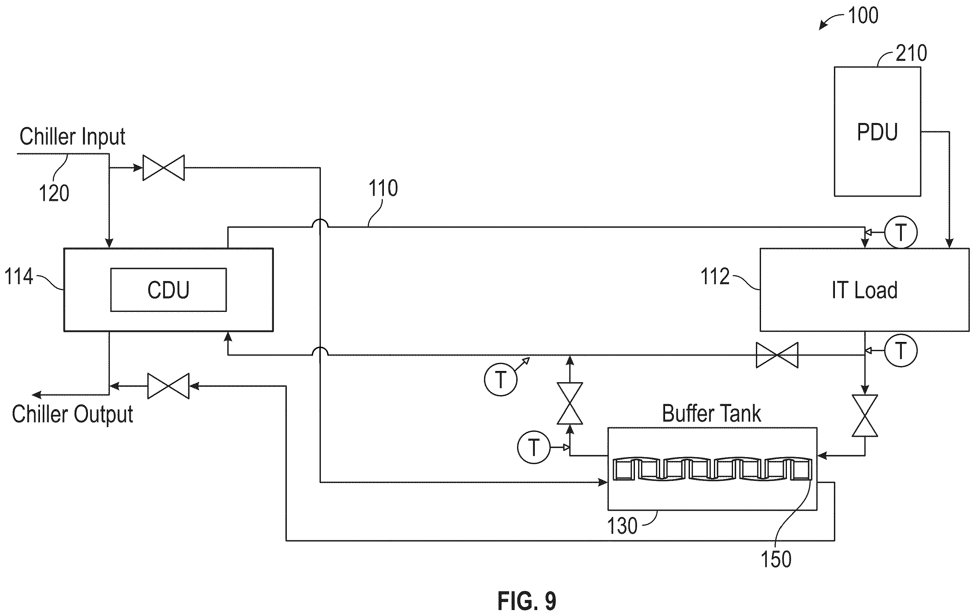

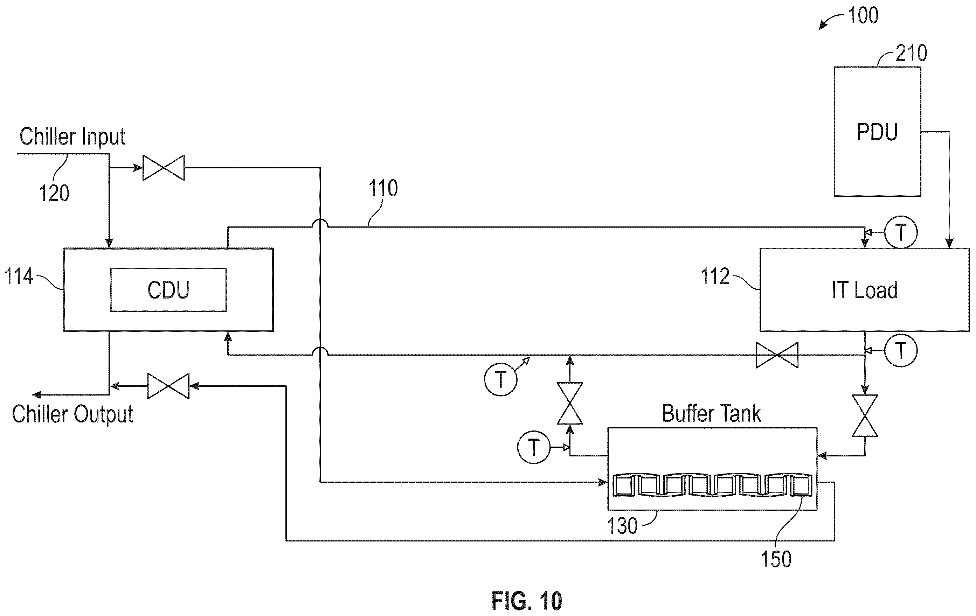

FIG. 1 is a simplified flow diagram of one of many embodiments of a cooling system according to the disclosure. FIG. 2 is a simplified flow diagram of another one of many embodiments of a cooling system according to the disclosure. FIG. 3 is a flow chart of one of many embodiments of a control scheme for a cooling system according to the disclosure. FIG. 4 is a flow chart of another one of many embodiments of a control scheme for a cooling system according to the disclosure. FIG. 5 is a partial schematic diagram of one of many embodiments of a cooling system according to the disclosure. FIG. 6 is a simplified diagram of one of many embodiments of a closed buffer tank for use with a cooling system according to the disclosure. FIG. 7 is a simplified diagram of one of many embodiments of an open buffer tank for use with a cooling system according to the disclosure. FIG. 8 is a simplified flow diagram of one of many embodiments of a cooling system having a buffer tank that is closed from the cold and hot liquid sides according to the disclosure. FIG. 9 is a simplified flow diagram of one of many embodiments of a cooling system having a buffer tank that is open from the cold liquid side and closed from the hot liquid side according to the disclosure. FIG. 10 is a simplified flow diagram of one of many embodiments of a cooling system having a buffer tank that is closed from the cold liquid side and open from the hot liquid side according to the disclosure. FIGS. 1-10 are described in conjunction with one another.

In at least one embodiment, a cooling system 100 according to the disclosure can include two or more cooling loops for extracting heat from one or more loads 200 and/or rejecting the heat, one or more controllers 300 for controlling one or more aspects of the cooling loops, or any combination thereof. In at least one embodiment, a first cooling loop 110 can include one or more load heat exchangers 112 for transferring heat from the load 200 to one or more cooling fluids (such as that circulating in the first cooling loop 110), one or more transfer heat exchangers 114 for transferring heat from the cooling fluid to one or more secondary cooling fluids (such as that circulating in a second cooling loop 120), one or more prime movers 116 for circulating the cooling fluid through at least a portion of the first cooling loop 110 (such as the load heat exchanger 112 and/or the transfer heat exchanger 114), one or more flow control valves 118 for controlling flow of the cooling fluid through the first cooling loop 110, or any combination thereof. In at least one embodiment, the second cooling loop 120 can include one or more rejection heat exchangers for rejecting heat from the secondary cooling fluid, such as to an exterior environment, and/or one or more secondary prime movers for circulating the second cooling fluid through at least a portion of the second cooling loop 120.

In at least one embodiment, the load heat exchanger 112 can be or include one or more direct-to-chip heat exchangers, one or more fluid-to-air heat exchangers, one or more fluid-to-fluid heat exchangers, one or more other heat exchangers, or any combination thereof. In at least one embodiment, the transfer heat exchanger 114 can be or include one or more brazed plate heat exchangers, one or more fluid-to-air heat exchangers, one or more fluid-to-fluid heat exchangers, one or more other heat exchangers, or any combination thereof. In at least one embodiment, the transfer heat exchanger 114 can be, or can be part of or included within, one or more other system components, such as a coolant distribution unit (CDU). In at least one embodiment, the cooling fluid can be or include one or more single-phase cooling fluids, such as water or a water/glycol mixture, and/or the prime mover 116 can be or include one or more pumps. In at least one embodiment, the cooling fluid can be or include one or more two-phase refrigerants and/or the prime mover 116 can be or include one or more compressors. In at least one embodiment, the cooling fluid circulating in the first cooling loop 110 can be the same as the secondary cooling fluid circulating in the second cooling loop 120.

In at least one embodiment, the controller 300 can monitor one or more sensors 310 for detecting one or more temperatures, one or more pressures, one or more other variables, or any combination thereof associated with the first cooling loop 110 and/or the second cooling loop 120. In at least one embodiment, the controller 300 can control the prime mover 116, the flow control valve 118, one or more other valves 320, 330, one or more other aspects of the first cooling loop 110 and/or the second cooling loop 120. In at least one embodiment, the controller 300 can be, include, or interact with one or more supervisory systems to control and/or otherwise interact with other aspects of a data center served by the cooling system 100. In at least one embodiment, the controller 300 can include or interact with one or more user interfaces for receiving user input and/or providing information to a user.

In at least one embodiment, the controller 300 can utilize the sensors 310 for monitoring one or more parameters, such as one or more load temperatures associated with the load 200, one or more return temperatures of the cooling fluid exiting the load heat exchanger 112 and/or entering the transfer heat exchanger 114, one or more supply temperatures of the cooling fluid entering the load heat exchanger 112 and/or exiting the transfer heat exchanger 114, one or more electrical power consumptions of the load 200, one or more flow rates through the first cooling loop 110 and/or the second cooling loop 120, or any combination thereof. In at least one embodiment, the parameter can be the load temperature. In at least one embodiment, the parameter and/or the load temperature can be a return temperature of the cooling fluid exiting the load heat exchanger 112. In at least one embodiment, the parameter and/or the load temperature can be a supply temperature of the cooling fluid entering the load heat exchanger 112. In at least one embodiment, the parameter can be an electrical power consumption of the load 200, which the controller 300 can obtain from a power distribution unit 210, or other component, supplying power to the load 200.

In at least one embodiment, the controller 300 can operate the prime mover 116 and/or the flow control valve 118 to maintain a load temperature associated with the load 200. In at least one embodiment, the controller 300 can selectively boost a cooling capacity of the first cooling loop 110 when a change in the parameter exceeds a first threshold. In at least one embodiment, the controller 300 can selectively control flow of the cooling fluid into and out of a buffer tank 130, such as by selectively one or more operating boost control valves 132. In at least one embodiment, the controller 300 can selectively replace, supplement, drain, fill, or any combination thereof, the cooling fluid in the buffer tank 130, such as by selectively operating one or more buffer fill valves 134. In at least one embodiment, the controller 300 can selectively add the secondary cooling fluid to the buffer tank 130 and/or replace the cooling fluid in the buffer tank 130 with the secondary cooling fluid, such as by selectively operating the buffer fill valves 134.

In at least one embodiment, boosting the cooling capacity of the first cooling loop 110 can include reducing the temperature of the cooling fluid entering the load heat exchanger 112 and/or the transfer heat exchanger 114, such as by replacing some or all of the hot cooling fluid circulating in the first cooling loop 110 with colder cooling fluid. In at least one embodiment, boosting the cooling capacity of the first cooling loop 110 can include replacing some or all of the cooling fluid exiting or entering the load heat exchanger 112 with colder cooling fluid, such as by drawing the colder cooling fluid into the first cooling loop 110 between the load heat exchanger 112 and the transfer heat exchanger 114. In at least one embodiment, boosting the cooling capacity of the first cooling loop 110 can include replacing some or all of the cooling fluid exiting the load heat exchanger 112 with colder cooling fluid upstream of the transfer heat exchanger 114. In at least one embodiment, boosting the cooling capacity of the first cooling loop 110 can include replacing some or all of the cooling fluid exiting or entering the load heat exchanger 112 with colder cooling fluid, such as from the buffer tank 130, using the boost control valves 132.

In at least one embodiment, the flow control valve 118 and/or the buffer tank 130 can be plumbed in series and/or parallel with the first cooling loop 110. In at least one embodiment, the flow control valve 118 and/or the buffer tank 130 can be plumbed between the load heat exchanger 112 and the transfer heat exchanger 114, upstream of either the load heat exchanger 112 or the transfer heat exchanger 114. In at least one embodiment, the flow control valve 118 and/or the buffer tank 130 can be plumbed upstream of the load heat exchanger 112 and downstream of the transfer heat exchanger 114, and the colder cooling fluid from the buffer tank 130 can enter the first cooling loop 110 upstream of the load heat exchanger 112 to cool the cooling fluid entering the load heat exchanger 112. In at least one embodiment, the flow control valve 118 and/or the buffer tank 130 can be plumbed downstream of the load heat exchanger 112 and upstream of the transfer heat exchanger 114, and the colder cooling fluid from the buffer tank 130 can enter the first cooling loop 110 downstream of the load heat exchanger 112 to cool the cooling fluid entering the transfer heat exchanger 114.

In at least one embodiment, boosting the cooling capacity of the first cooling loop 110 can include diverting a first portion of the cooling fluid exiting the load heat exchanger 112 to a buffer tank 130, which can be plumbed in parallel with the flow control valve 118. In at least one embodiment, boosting the cooling capacity of the first cooling loop 110 can include drawing a second portion of the cooling fluid from the buffer tank 130. In at least one embodiment, the first portion can be hotter than the second portion and/or the first portion can be volumetrically identical (i.e., at least substantially and/or functionally volumetrically identical) to the second portion.

In at least one embodiment, a method 400 according to the disclosure can include one or more normal operations control schemes, which can be based at least in part on the temperature associated with the load, and/or one or more abnormal operations control schemes, which can be based at least in part on the temperature associated with the load and/or one or more other parameters. In at least one embodiment, the controller 300 perform any or all of the method 400, such as the normal operations control scheme and/or the abnormal operations control scheme, and/or other actions. In at least one embodiment, the controller 300 can perform any or all of the normal operations control scheme simultaneously with the abnormal operations control scheme. In at least one embodiment, the normal operations control scheme can include operating the prime mover 116 and/or the flow control valve 118 based on the load temperature, such as increasing the flow of the cooling fluid through the first loop 110, as the load temperature increases. In at least one embodiment, operating the prime mover 116 and/or the flow control valve 118 based on the load temperature can include operating the prime mover 116 and/or the flow control valve 118 proportionally to the load temperature, i.e., opening the flow control valve 118 to a greater extent as the load temperature increases. In at least one embodiment, the normal operations control scheme can also include increasing the flow of the cooling fluid through the second cooling loop 120, as the load temperature increases, such as for transferring the increasing heat from the load 200 from the first cooling loop 110.

In at least one embodiment, significant fluctuations in the load temperature, the return temperature, another parameter, or any combination thereof can cause the parameter to rise faster than the normal operations control scheme can accommodate, which can lead to the cooling fluid entering the load heat exchanger 112 at elevated temperatures. In at least one embodiment, the abnormal operations control scheme can boost the cooling capacity of the normal operations control scheme and/or the first cooling loop 110 and prevent or delay the cooling fluid entering the load heat exchanger 112 at elevated temperatures for an adequate amount of time to allow the normal operations control scheme to react to the increased temperature or other parameter.

In at least one embodiment, during normal operations, such as when the return temperature is not changing rapidly and/or when the change in the return temperature (or another parameter) is below the first threshold, the controller 300 can operate the flow control valve 118 normally, such as proportionally to the return temperature and/or otherwise according to the normal operations control scheme. In at least one embodiment, when the change in the return temperature (or another parameter) exceeds the first threshold and is below a second threshold, the controller 300 can reduce flow through the flow control valve 118 (such as by maintaining a flow rate through the prime mover 116 and/or partially closing the flow control valve 118) and replace some of the cooling fluid exiting the load heat exchanger 112 with colder cooling fluid stored in the buffer tank 130, such as by opening the boost control valves 132. In at least one embodiment, when the change in the return temperature (or another parameter) exceeds the second threshold, the controller 300 can operate prime mover 116 and/or the flow control valve 118 normally, such as proportionally to the return temperature and/or otherwise according to the normal operations control scheme, and replace some of the first cooling fluid exiting the load heat exchanger 112 with the colder cooling fluid stored in the buffer tank 130. In at least one embodiment, the second threshold can be greater than the first threshold.

In at least one embodiment, when the change in the parameter is below the first threshold (normal operations), the controller 300 can maintain the temperature associated with the load 200 by controlling a flow rate of the cooling fluid through the first cooling loop 110, such as through control of the prime mover 116 and/or the flow control valve 118. In at least one embodiment, when the change in the parameter exceeds the first threshold (abnormal operations), the controller 300 can boost the cooling capacity of the first cooling loop 110 by increasing the flow rate and/or a volume of the cooling fluid flowing through the first cooling loop, such as through control of the prime mover 116, the flow control valve 118, one or more other valves 132, or any combination thereof.

In normal operations, the return temperature can be expected to fluctuate to some extent, such as up to 10%, 15%, 20%, 25%, or 30%, for example. In at least one embodiment, when there are minimal and/or normal fluctuations (such as when the change in the return temperature (or another parameter) is below the first threshold, e.g., 20%), the controller 300 can operate the prime mover 116 and/or the flow control valve 118 normally, such as proportionally to the return temperature and/or according to a normal operation control scheme, as shown in step 410.

In at least one embodiment, when there is a minor fluctuation (such as when the change in the return temperature (or another parameter) exceeds the first threshold and is below a second threshold, e.g., 30%), the controller 300 can operate the prime mover 116 and/or the flow control valve 118 more dramatically (more aggressively) than otherwise called for by the return temperature itself, such as disproportionally greater and/or more than that called for by the normal operations control scheme, as shown in step 420. In at least one embodiment, by opening the flow control valve 118 disproportionally greater and/or more dramatically, the controller 300 can react faster to the change in the return temperature (or another parameter) and/or accommodate minor fluctuations beyond normal operations.

In at least one embodiment, when there is a moderate fluctuation (such as when the change in the return temperature (or another parameter) exceeds the second threshold and is below a third threshold, e.g., 50%), the controller 300 can replace some of the hotter cooling fluid exiting the load heat exchanger 112 with colder cooling fluid, with or without increasing a flow rate of the cooling fluid through the first cooling loop 110. In at least one embodiment, when there is a moderate fluctuation (such as when the change in the return temperature exceeds the second threshold and is below a third threshold), the controller 300 can reduce flow through the flow control valve 118 and replace some or all of the cooling fluid exiting the load heat exchanger 112 with colder cooling fluid stored in a buffer tank 130, as shown in step 430.

In at least one embodiment, when there is a major, or more dramatic, fluctuation (such as when the change in the return temperature (or another parameter) exceeds the third threshold, e.g., 50%), the controller 300 can operate the prime mover 116 and/or the flow control valve 118 normally, such as proportionally to the return temperature and/or according to the normal operations control scheme, and replace some of the cooling fluid exiting the load heat exchanger 112 with the colder cooling fluid stored in the buffer tank 130, as shown in step 440. In at least one embodiment, when there is a more dramatic fluctuation (such as when the change in the return temperature (or another parameter) exceeds the third threshold), the controller 300 can maintain flow through the flow control valve 118 and replace some of the cooling fluid exiting the load heat exchanger 112 with colder cooling fluid stored in the buffer tank 130. In at least one embodiment, when there is a more dramatic fluctuation (such as when the change in the return temperature (or another parameter) exceeds the third threshold), the controller 300 can maintain flow through the flow control valve 110 and draw some or all of the colder cooling fluid stored in the buffer tank 130 into the first cooling loop 110. In at least one embodiment, the second threshold can be greater than the first threshold. In at least one embodiment, the third threshold can be greater than the first threshold and/or the second threshold.

In at least one embodiment, boosting the cooling capacity of the first cooling loop 110 can include inducing the cooling fluid to flow through a supplemental heat exchanger 140. In at least one embodiment, the supplemental heat exchanger 140 can be plumbed in parallel with the transfer heat exchanger 114 and/or transfer heat from the cooling fluid to another cooling fluid (such as the secondary cooling fluid). In at least one embodiment, inducing the cooling fluid to flow through the supplemental heat exchanger 140 can increase a flow rate through the load heat exchanger 112 and/or reduce a flow rate through the transfer heat exchanger 114. In at least one embodiment, the controller 300 can induce the cooling fluid to flow through the load heat exchanger 112 at a first flow rate, induce the cooling fluid to flow through the transfer heat exchanger 114 at a second flow rate, induce the cooling fluid to flow through the supplemental heat exchanger 140 at a third flow rate, or any combination thereof. In at least one embodiment, the first flow rate can be higher than the second flow rate and/or the third flow rate. In at least one embodiment, the first flow rate can be equal to the sum of the second flow rate and the third flow rate.

In at least one embodiment, boosting the cooling capacity of the first cooling loop 110 can include increasing a flow rate and/or a volume of the cooling fluid through the first cooling loop 110. In at least one embodiment, boosting the cooling capacity of the first cooling loop 110 can include drawing additional cooling fluid from a buffer tank 130, which can be plumbed in parallel with a portion of the first cooling loop 110, such as the flow control valve 118. In at least one embodiment, boosting the cooling capacity of the first cooling loop 110 can include diverting at least a portion of the cooling fluid exiting the load heat exchanger 112 and/or the transfer heat exchanger 114 to a buffer tank 130.

In at least one embodiment, the controller 300 can replenish the cooling fluid in the buffer tank 130, such as by operating the buffer fill valves 134, as shown in step 450. In at least one embodiment, the controller 300 can monitor a buffer temperature of the cooling fluid in the buffer tank 130 and replace, such as when the buffer temperature exceeds a second threshold, a third portion of the cooling fluid in the buffer tank 130 with a fourth portion of another cooling fluid, such as the secondary cooling fluid in the second cooling loop 120. In at least one embodiment, the third portion can be volumetrically identical to the fourth portion. In at least one embodiment, the controller 300 can monitor a level of the cooling fluid in the buffer tank 130 and refill the buffer tank 130, such as when the level is below a threshold, e.g., 80%, with another cooling fluid, such as the secondary cooling fluid in the second cooling loop 120.

In at least one embodiment, the buffer tank 130 can be a closed tank, such as that illustrated in FIG. 6, and/or the cooling fluid flowing through the first cooling loop 110 can be isolated from the cooling fluid flowing from and/or to the second cooling loop 120. In at least one embodiment, the buffer tank 130 can include one or more heat exchangers 150 disposed therein to provide heat transfer between, as well as isolation of, one or more cooling fluids. In at least one embodiment, such as where the buffer tank 130 is a closed tank, the cooling fluid flowing through the first cooling loop 110 can be different than the cooling fluid flowing from and/or to the second cooling loop 120. In at least one embodiment, either or both of the cooling fluids can be or include water, a water-glycol mixture, a refrigerant, a wax, or any combination thereof.

In at least one embodiment, the buffer tank 130 can be an open tank, such as that illustrated in FIG. 7, and/or the cooling fluid flowing through the first cooling loop 110 can be mixed with the cooling fluid flowing from and/or to the second cooling loop 120. In at least one embodiment, such as where the buffer tank 130 is an open tank, the system 100 can include filtration and/or other purification equipment for ensuring sufficient purity of the cooling fluid and/or to avoid compromise of the heat exchangers 112, 114. In at least one embodiment, an open buffer tank 130 can allow cooling of the cooling fluid therein through mixing. In at least one embodiment, the system 100 can include one or more additional cooling loops 160, which can include one or more additional heat exchangers (not shown) for cooling down the contents of the buffer tank 130 or, as another example, which can be or include being in fluid communication with second cooling loop 120 for cooling down the contents of the buffer tank 130.

In at least one embodiment, one or more buffer tanks 130 can be closed from the cold and hot liquid sides, such as by way of having heat exchangers 150 disposed therein on both the cold and hot liquid sides (see, e.g., FIG. 8). In such an embodiment, which is but one of many, the contents of the buffer tank 130 can, but need not, be different from the hot and cold media flowing through the heat exchangers 150. In at least one embodiment, one or more buffer tanks 130 can be open from the cold liquid side and closed from the hot liquid side, such as by way of having a heat exchanger 150 disposed therein on the hot liquid side (see, e.g., FIG. 9). In such an embodiment, which is but one of many, the contents of the buffer tank 130 can be the same as the cold media. In at least one embodiment, one or more buffer tanks 130 can be open from the hot liquid side and closed from the cold liquid side, such as by way of having a heat exchanger 150 disposed therein on the cold liquid side (see, e.g., FIG. 10). In such an embodiment, which is but one of many, the contents of the buffer tank 130 can be the same as the hot media.

As will be appreciated by those skilled in the art having the benefits of the present disclosure, aspects of one or more embodiments of the disclosure can be embodied as a system, method or computer program product. Accordingly, aspects of the present embodiments can take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present disclosure may take the form of a computer program product embodied in one or more non-transitory computer readable mediums having computer readable program code embodied thereon. Any combination of one or more computer readable media may be utilized. The computer readable media may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples of such computer readable storage media include but are not limited to the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain or store a program for use by or in connection with an instruction execution system, apparatus, or device.

Program code embodied on a computer readable medium may be transmitted using any appropriate medium or media, including but not limited to wireless, wireline, optical fiber cable, radio frequency (RF), or any suitable combination of the foregoing. Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on a user's computer, partly on a user's computer, as a stand-alone software package, partly on a user's computer and partly on a remote computer, or entirely on a remote computer or server. In the latter scenario, the remote computer may be connected to a user's computer through any type of network, including a local area network (LAN) or a wide area network (WAN), or the connection may be made to an external computer (for example, through the Internet using an Internet Service Provider or via a short-range wireless interconnection such as Bluetooth).

Aspects of the present disclosure can be described with reference to flowchart illustrations and/or block diagrams of methods, apparatuses (devices and systems) and computer program products according to embodiments of the disclosure. Each block of a flowchart illustration and/or block diagram, and combinations of blocks in a flowchart illustration and/or block diagrams, can be implemented by computer program instructions. These computer program instructions may be provided to a processor of a general purpose computer, special purpose computer, or other programmable data processing apparatus to produce a machine, such that the instructions, which executed via one or more processors, create means for implementing the functions/acts specified in the flowchart and/or block diagram block or blocks. The computer program instructions can be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks. The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks. Each block in a flowchart and/or block diagram can be split into multiple blocks and/or combined with other blocks to make a single block.

In at least one embodiment, a cooling system according to the disclosure can include a first cooling loop for extracting heat from a load, a second cooling loop for rejecting the heat, a controller for controlling one or more aspects of the first cooling loop and/or the second cooling loop, or any combination thereof. In at least one embodiment, the first cooling loop can include a first heat exchanger for transferring heat from the load to a first cooling fluid (such as that circulating in the first cooling loop), a second heat exchanger for transferring heat from the first cooling fluid to a second cooling fluid (such as that circulating in the second cooling loop), a prime mover for circulating the first cooling fluid through at least a portion of the first cooling loop (such as the first heat exchanger and the second heat exchanger), a flow control valve for controlling flow of the first cooling fluid through the first cooling loop, or any combination thereof. In at least one embodiment, the controller can monitor a parameter and/or operate the flow control valve to maintain a load temperature associated with the load. In at least one embodiment, the controller can selectively boost a cooling capacity of the first cooling loop when a change in the parameter exceeds a first threshold.

In at least one embodiment, the first heat exchanger can be a direct-to-chip heat exchanger. In at least one embodiment, the second heat exchanger can be a brazed plate heat exchanger. In at least one embodiment, the first cooling fluid can be a single-phase cooling fluid, such as water or a water/glycol mixture, and/or the prime mover can be a pump. In at least one embodiment, the first cooling fluid can be a two-phase refrigerant and/or the prime mover can be a compressor. In at least one embodiment, the first cooling fluid can be the same as the second cooling fluid.

In at least one embodiment, the parameter can be the load temperature. In at least one embodiment, the parameter and/or the load temperature can be a return temperature of the first cooling fluid exiting the first heat exchanger. In at least one embodiment, the parameter and/or the load temperature can be a supply temperature of the first cooling fluid entering the first heat exchanger. In at least one embodiment, the parameter can be an electrical power consumption of the load.

In at least one embodiment, boosting the cooling capacity of the first cooling loop can include reducing the temperature of the cooling fluid entering the first heat exchanger and/or the second heat exchanger, such as by replacing some or all of the hot cooling fluid circulating in the first cooling loop with colder cooling fluid. In at least one embodiment, boosting the cooling capacity of the first cooling loop can include replacing some or all of the first cooling fluid exiting or entering the first heat exchanger with colder cooling fluid, such as by drawing the colder cooling fluid into the first cooling loop between the first heat exchanger and the second heat exchanger. In at least one embodiment, boosting the cooling capacity of the first cooling loop can include replacing some or all of the first cooling fluid exiting the first heat exchanger with colder cooling fluid upstream of the second heat exchanger.

In at least one embodiment, boosting the cooling capacity of the first cooling loop can include diverting a first portion of the first cooling fluid exiting the first heat exchanger to a buffer tank, which can be plumbed in parallel with the flow control valve. In at least one embodiment, boosting the cooling capacity of the first cooling loop can include drawing a second portion of the first cooling fluid from the buffer tank. In at least one embodiment, the first portion can be hotter than the second portion. In at least one embodiment, the first portion can be volumetrically identical to the second portion.

In at least one embodiment, the controller can monitor a buffer temperature of the first cooling fluid in the buffer tank and replace, such as when the buffer temperature exceeds a second threshold, a third portion of the first cooling fluid in the buffer tank with a fourth portion of the second cooling fluid, such as from the second cooling loop. In at least one embodiment, the third portion can be volumetrically identical to the fourth portion.

In at least one embodiment, during normal operations, such as when the return temperature is not changing rapidly and/or when the change in the return temperature is below the first threshold, the controller can operate the flow control valve normally, such as proportionally to the return temperature. In at least one embodiment, when the change in the return temperature exceeds the first threshold and is below a second threshold, the controller can reduce flow through the flow control valve and replace some of the first cooling fluid exiting the first heat exchanger, such as at a higher temperature, with colder cooling fluid stored in a buffer tank, which can be plumbed in parallel with the flow control valve. In at least one embodiment, when the change in the return temperature exceeds the second threshold, the controller can operate the flow control valve normally, such as proportionally to the return temperature, and replace some of the first cooling fluid exiting the first heat exchanger with the colder cooling fluid stored in the buffer tank. In at least one embodiment, the second threshold can be greater than the first threshold.

In at least one embodiment, when the change in the parameter is below the first threshold (normal operations), the controller can maintain the temperature associated with the load by controlling a flow rate of the first cooling fluid through the first cooling loop, such as through control of the flow control valve and/or the prime mover. In at least one embodiment, when the change in the parameter exceeds the first threshold (abnormal operations), the controller can boost the cooling capacity of the first cooling loop by increasing the flow rate and/or a volume of the first cooling fluid flowing through the first cooling loop, such as through control of the flow control valve, the prime mover, one or more other valves, or any combination thereof.

In normal operations, the return temperature is expected to fluctuate to some extent. In at least one embodiment, when there are minimal and/or normal fluctuations (such as when the change in the return temperature is below the first threshold), the controller can operate the flow control valve normally, such as proportionally to the return temperature and/or according to a normal operations control scheme, which can be based at least in part on the temperature associated with the load.

In at least one embodiment, when there is a minor fluctuation (such as when the change in the return temperature exceeds the first threshold and is below a second threshold), the controller can operate the flow control valve more dramatically than otherwise called for by the return temperature itself, such as opening the flow control valve disproportionally greater and/or more than that called for by the scheme. In at least one embodiment, by opening the flow control valve disproportionally greater and/or more dramatically, the controller can react faster to the change in the return temperature and/or accommodate minor fluctuations beyond normal operations.

In at least one embodiment, when there is a moderate fluctuation (such as when the change in the return temperature exceeds the second threshold and is below a third threshold), the controller can replace some of the hotter cooling fluid exiting the first heat exchanger with colder cooling fluid, with or without increasing a flow rate of the cooling fluid through the first cooling loop. In at least one embodiment, when there is a moderate fluctuation (such as when the change in the return temperature exceeds the second threshold and is below a third threshold), the controller can reduce flow through the flow control valve and replace some or all of the first cooling fluid exiting the first heat exchanger with colder cooling fluid stored in a buffer tank, which can be plumbed in parallel with the flow control valve.

In at least one embodiment, when there is a more dramatic fluctuation (such as when the change in the return temperature exceeds the third threshold), the controller can operate the flow control valve normally, such as proportionally to the return temperature and/or according to the scheme, and replace some of the first cooling fluid exiting the first heat exchanger with the colder cooling fluid stored in the buffer tank. In at least one embodiment, when there is a more dramatic fluctuation (such as when the change in the return temperature exceeds the third threshold), the controller can maintain flow through the flow control valve and replace some of the first cooling fluid exiting the first heat exchanger with colder cooling fluid stored in the buffer tank. In at least one embodiment, when there is a more dramatic fluctuation (such as when the change in the return temperature exceeds the third threshold), the controller can maintain flow through the flow control valve and draw some or all of the colder cooling fluid stored in the buffer tank into the first cooling loop. In at least one embodiment, the second threshold can be greater than the first threshold. In at least one embodiment, the third threshold can be greater than the first threshold and/or the second threshold.

In at least one embodiment, boosting the cooling capacity of the first cooling loop can include inducing the first cooling fluid to flow through a third heat exchanger. In at least one embodiment, the third heat exchanger can be plumbed in parallel with the second heat exchanger and/or transfer heat from the first cooling fluid to another cooling fluid (such as the second cooling fluid). In at least one embodiment, inducing the first cooling fluid to flow through the third heat exchanger can increase a flow rate through the first heat exchanger and/or reduce a flow rate through the second heat exchanger. In at least one embodiment, the controller can induce the first cooling fluid to flow through the first heat exchanger at a first flow rate, induce the first cooling fluid to flow through the second heat exchanger at a second flow rate, induce the first cooling fluid to flow through the third heat exchanger at a third flow rate, or any combination thereof. In at least one embodiment, the first flow rate can be higher than the second flow rate and/or the third flow rate. In at least one embodiment, the first flow rate can be equal to the sum of the second flow rate and the third flow rate.

In at least one embodiment, boosting the cooling capacity of the first cooling loop can include increasing a flow rate and/or a volume of the first cooling fluid through the first cooling loop. In at least one embodiment, boosting the cooling capacity of the first cooling loop can include drawing additional cooling fluid from a buffer tank, which can be plumbed in parallel with a portion of the first cooling loop, such as the flow control valve. In at least one embodiment, boosting the cooling capacity of the first cooling loop can include diverting at least a portion of the first cooling fluid exiting the first heat exchanger and/or the second heat exchanger to a buffer tank.

Other and further embodiments utilizing one or more aspects of the disclosure can be devised without departing from the Applicant's disclosure. For example, the devices, systems and methods can be implemented for numerous different types and sizes in numerous different industries. Further, the various methods and embodiments of the devices, systems and methods can be included in combination with each other to produce variations of the disclosed methods and embodiments. Discussion of singular elements can include plural elements and vice versa. The order of steps can occur in a variety of sequences unless otherwise specifically limited. The various steps described herein can be combined with other steps, interlineated with the stated steps, and/or split into multiple steps. Similarly, elements have been described functionally and can be embodied as separate components or can be combined into components having multiple functions.

The disclosure has been described in the context of preferred and other embodiments and not every embodiment of the disclosure has been described. Obvious modifications and alterations to the described embodiments are available to those of ordinary skill in the art having the benefits of the present disclosure. The disclosed and undisclosed embodiments are not intended to limit or restrict the scope or applicability of the disclosure conceived of by the Applicant, but rather, in conformity with the patent laws, Applicant intends to fully protect all such modifications and improvements that come within the scope of the following claims.

## Claims

1. A cooling system (100) comprising:
a first cooling loop (110) comprising:
a first heat exchanger (112) configured to transfer heat from a load (200) to a first cooling fluid;
a second heat exchanger (114) configured to transfer heat from the first cooling fluid to a second cooling fluid;
a prime mover (116) configured to circulate the first cooling fluid through the first heat exchanger and the second heat exchanger; and
a flow control valve (118) configured to control flow of the first cooling fluid through the first cooling loop; and
a controller (300) configured to:
monitor a parameter; and
operate the flow control valve to maintain a load temperature associated with the load;
wherein the controller is further configured to boost a cooling capacity of the first cooling loop when a change in the parameter exceeds a first threshold.

2. The cooling system as set forth in claim 1, wherein the first heat exchanger is a direct-to-chip heat exchanger.

3. The cooling system as set forth in claim 1 or 2, wherein the second heat exchanger is a brazed plate heat exchanger.

4. The cooling system as set forth in any preceding claim, wherein the first cooling fluid includes water and the prime mover is a pump.

5. The cooling system as set forth in any preceding claim, wherein the first cooling fluid is a two-phase refrigerant and the prime mover is a compressor.

6. The cooling system as set forth in any preceding claim, wherein the parameter is the load temperature.

7. The cooling system as set forth in any preceding claim, wherein the parameter is a return temperature of the first cooling fluid exiting the first heat exchanger.

8. The cooling system as set forth in any preceding claim, wherein the parameter is a supply temperature of the first cooling fluid entering the first heat exchanger, or wherein the parameter is an electrical power consumption of the load.

9. The cooling system as set forth in any preceding claim, wherein boosting the cooling capacity of the first cooling loop comprises replacing at least a portion of the first cooling fluid exiting the first heat exchanger with colder cooling fluid upstream of the second heat exchanger, and/or wherein boosting the cooling capacity of the first cooling loop comprises replacing at least a portion of the first cooling fluid exiting the second heat exchanger with colder cooling fluid upstream of the first heat exchanger.

10. The cooling system as set forth in any preceding claim, wherein boosting the cooling capacity of the first cooling loop comprises diverting a first portion of the first cooling fluid exiting the first heat exchanger to a buffer tank (130) plumbed in parallel with the flow control valve and drawing a second portion of the first cooling fluid from the buffer tank, wherein the first portion is hotter than the second portion.

11. The cooling system as set forth in claim 10, wherein the first portion and the second portion are volumetrically identical, and/or wherein the controller is configured to monitor a buffer temperature of the first cooling fluid in the buffer tank and replace, when the buffer temperature exceeds a second threshold, a third portion of the first cooling fluid in the buffer tank with a fourth portion of the second cooling fluid.

12. The cooling system as set forth in any preceding claim, wherein the parameter is a return temperature of the first cooling fluid exiting the first heat exchanger; and wherein the controller is configured to:
operate the flow control valve proportionally to the return temperature, when the change in the return temperature is below the first threshold;
reduce flow through the flow control valve and replace at least a portion of the first cooling fluid exiting the first heat exchanger with colder cooling fluid stored in a buffer tank plumbed in parallel with the flow control valve, when the change in the return temperature exceeds the first threshold and is below a second threshold; and
operate the flow control valve proportionally to the return temperature and replace at least a portion of the first cooling fluid exiting the first heat exchanger with the colder cooling fluid stored in the buffer tank, when the change in the return temperature exceeds the second threshold; and
wherein the second threshold is greater than the first threshold.

13. The cooling system as set forth in any preceding claim, wherein the parameter is a return temperature of the first cooling fluid exiting the first heat exchanger; and wherein the controller is configured to:
operate the flow control valve proportionally to the return temperature, when the change in the return temperature is below the first threshold;
operate the flow control valve disproportionally to the return temperature, when the change in the return temperature exceeds the first threshold and is below a second threshold;
reduce flow through the flow control valve and replace at least a portion of the first cooling fluid exiting the first heat exchanger with colder cooling fluid stored in a buffer tank plumbed in parallel with the flow control valve, when the change in the return temperature exceeds the second threshold and is below a third threshold; and
operate the flow control valve proportionally to the return temperature and replace at least a portion of the first cooling fluid exiting the first heat exchanger with the colder cooling fluid stored in the buffer tank, when the change in the return temperature exceeds the third threshold;
wherein the second threshold is greater than the first threshold; and
wherein the third threshold is greater than the second threshold,
and/or wherein the controller is further configured to:
maintain the temperature associated with the load by controlling a flow rate of the first cooling fluid through the first cooling loop, using the flow control valve, when the change in the parameter is below the first threshold; and
boost the cooling capacity of the first cooling loop by increasing a volume of the first cooling fluid flowing through the first cooling loop, when the change in the parameter exceeds the first threshold.

14. The cooling system as set forth in any preceding claim, wherein boosting the cooling capacity of the first cooling loop comprises inducing the first cooling fluid to flow through a third heat exchanger (140) plumbed in parallel with the second heat exchanger.

15. The cooling system as set forth in claim 14, wherein the third heat exchanger is configured to transfer heat from the first cooling fluid to the second cooling fluid and/or wherein the controller is configured to:
induce the first cooling fluid to flow through the first heat exchanger at a first flow rate;
induce the first cooling fluid to flow through the second heat exchanger at a second flow rate; and
induce the first cooling fluid to flow through the third heat exchanger at a third flow rate;
wherein the first flow rate is higher than the second flow rate; and
wherein the first flow rate is higher than the third flow rate.
